Europäisches Patentamt

European Patent Office

Office européen des brevets

(19)

(11) Numéro de publication : **0 275 290 B1**

# (12) FASCICULE DE BREVET EUROPEEN

(45) Date de publication du fascicule du brevet :
**23.10.91 Bulletin 91/43**

(51) Int. Cl.⁵ : **G11B 5/70, H05K 9/00, G06K 19/08**

(21) Numéro de dépôt : **87904887.4**

(22) Date de dépôt : **21.07.87**

(86) Numéro de dépôt international :
**PCT/FR87/00290**

(87) Numéro de publication internationale :
**WO 88/01091 11.02.88 Gazette 88/04**

(54) **DISPOSITIF DE PROTECTION, CONTRE LE FLUX MAGNETIQUE ENVIRONNANT, D'OBJETS SUSCEPTIBLES D'ETRE ALTERES PAR UN FLUX MAGNETIQUE, NOTAMMENT D'OBJETS PRESENTANT UN SUPPORT D'INSCRIPTIONS MAGNETIQUES.**

(30) Priorité : **29.07.86 FR 8610960**

(43) Date de publication de la demande :
**27.07.88 Bulletin 88/30**

(45) Mention de la délivrance du brevet :
**23.10.91 Bulletin 91/43**

(84) Etats contractants désignés :
**AT BE CH DE GB IT LI LU NL SE**

(56) Documents cités :
**DE-A- 1 812 660**
**DE-A- 2 631 091**
**US-A- 4 174 419**

(73) Titulaire : **LESAGE, Christian**
**44, rue Gustave Flaubert**
**F-50110 Tourlaville (FR)**

(72) Inventeur : **LESAGE, Christian**
**44, rue Gustave Flaubert**
**F-50110 Tourlaville (FR)**

(74) Mandataire : **L'Helgoualch, Jean**
**Cabinet Sueur et L'Helgoualch 78, rue Carnot**
**F-95240 Cormeilles-en-Parisis (FR)**

## Description

L'invention est relative à un dispositif de protection, contre l'environnement magnétique, d'objets susceptibles d'être altérés par un flux magnétique, notamment d'objets présentant un support d'inscriptions magnétiques ; de tels objets peuvent être des cartes bancaires, des tickets d'accès aux transports en commun, des disquettes ou disques d'ordinateur isolés ou dans leur lecteur-enregistreur.

On a constaté une agressivité de plus en plus grande de l'environnement électromagnétique qui s'est trouvée aller de pair avec la multiplication des objets susceptibles d'être altérés par un flux magnétique.

C'est ainsi que, à titre d'exemple, on peut indiquer qu'un haut-parleur de bonne qualité pour la sonorisation d'une automobile (haut-parleur triaxial) engendre dans son entrefer dans le voisinage immédiat de la bobine un champ d'environ 1 432 395 A/m (18 000 Oe); ce haut-parleur, disposé sur la plage arrière ou dans une portière d'automobile, peut se trouver à proximité d'un objet susceptible d'être altéré par un flux magnétique, tel par exemple qu'une carte bancaire dont le support d'inscriptions magnétiques présente un champ coercitif d'environ 23 873 A/m (300 Oe). L'action d'un champ magnétique environnant 60 fois plus important que le champ coercitif d'un tel support d'inscriptions magnétiques de la carte bancaire provoque donc une démagnétisation totale ou partielle dudit support et rend la carte bancaire inutilisable dans tout dispositif de lecture de son support.

L'invention a donc pour but un dispositif destiné à protéger, contre une influence magnétique indésirable, tout objet susceptible d'être altéré par un flux magnétique, sans augmenter le champ magnétique coercitif dudit objet.

Le brevet DE-A-2 631 091 décrit un dispositif de protection faisant appel à une plaque ou une bobine métallique incorporée dans un matériau plastique. Cette plaque ou bobine métallique agit comme une cage de Faraday.

Cette cage de Faraday assure donc une protection contre des champs électrostatiques ou des ondes électromagnétiques, et son efficacité est accrue dans la mesure où elle est reliée à la terre.

Cependant, elle n'a pratiquement aucune action sur le flux magnétique environnant.

Cette disposition basée sur l'effet procuré par une cage de Faraday ne peut donc être comparée à la disposition faisant l'objet de la présente demande de brevet qui est applicable à la protection contre un flux magnétique environnant, protection qui est obtenue en faisant appel à des matériaux définis dans la revendication 1 de cette demande présentant d'une part un coefficient de perméabilité magnétique élevé supérieur à 5 000 et d'autre part un champ magnétique coercitif faible inférieur à 159 A/m (2 Oe).

Il est d'ailleurs intéressant de remarquer que la protection par cage de Faraday contre les champs électrostatiques ou les ondes électromagnétiques ne présente pas grand intérêt étant donné le peu d'influence sur la conservation des informatiques stockées sur un support magnétique des champs électrostatiques ou des ondes électromagnétiques.

Le brevet US-A-4 174 419 décrit un matériau (metal glass) dont la structure est amorphe, ce qui présente l'intérêt de conserver un coefficient de perméabilité magnétique élevé après déformation mécanique supérieure à la limite élastique.

Il s'agit là d'un document décrivant uniquement un matériau nouveau et non pas les applications qu'il est possible d'en faire.

Le brevet DE-A-1 812 660 décrit un dispositif montrant une structure "sandwich" (dans sa figure 2) comportant une couche intermédiaire constituée par une bande de métal plié interposée entre deux éléments de plaque.

Cette couche intermédiaire ne peut donc en aucun cas être assimilée à la couche formée d'un corps amagnétique faisant l'objet des revendications 3 et 4 de la présente demande de brevet.

Pour atteindre le but rappelé plus haut, le dispositif conforme à l'invention comporte au moins une couche protectrice formée d'un matériau présentant, d'une part, un coefficient de perméabilité magnétique élevé, supérieur à 5 000, et, d'autre part, un champ magnétique coercitif faible, inférieur à 159 A/m (2 Oe) et la couche protectrice est revêtue d'une couche dite "couche d'écartement", formée d'un corps amagnétique et dont l'épaisseur permet de maintenir l'objet à protéger à une distance déterminée de la couche protectrice.

Le dispositif peut avantageusement comporter au moins deux couches protectrices séparées par une couche intermédiaire formée d'un corps amagnétique ; dans ce cas le nombre de couches croît avec la valeur du champ magnétique contre lequel on recherche une protection.

La distance déterminée précitée peut être du même ordre de grandeur que l'épaisseur de la couche protectrice.

La couche protectrice peut être revêtue d'une couche extérieure formée d'un corps amagnétique.

Selon une première disposition constructive, la couche intermédiaire peut être réalisée en faisant appel à un corps alvéolaire.

Selon une autre disposition constructive la couche intermédiaire et/ou la couche d'écartement et/ou la couche extérieure sont formées par le même corps amagnétique.

Avantageusement, la couche protectrice peut être constituée par un alliage à base de fer et de nickel ou à base de fer, de nickel et de molybdène, ou un alliage à base de fer, de nickel et de bore, ou un alliage à base de fer, de nickel, de bore et de phosphore.

L'invention s'applique à la réalisation d'étuis, de boîtiers, de carters ou de toute autre structure, et ce en fonction de l'objet ou des objets à protéger.

L'invention consiste, mises à part les dispositions dont il vient d'être question, en certaines autres dispositions qui s'utilisent de préférence en même temps, et qui seront plus explicitement discutées ci-après.

L'invention pourra, de toute façon, être bien comprise à l'aide du complément de description qui suit ainsi que du dessin ci-annexé, lesquels complément et dessin sont relatifs à des formes d'exécution préférées de l'invention et ne comportent, bien entendu, aucun caractère limitatif.

La figure 1, de ces dessins, montre en coupe, un matériau conforme à l'invention.

Les figures 2 à 4 montrent, en coupe, trois formes d'exécution d'un étui réalisé à partir d'un matériau conforme à l'invention.

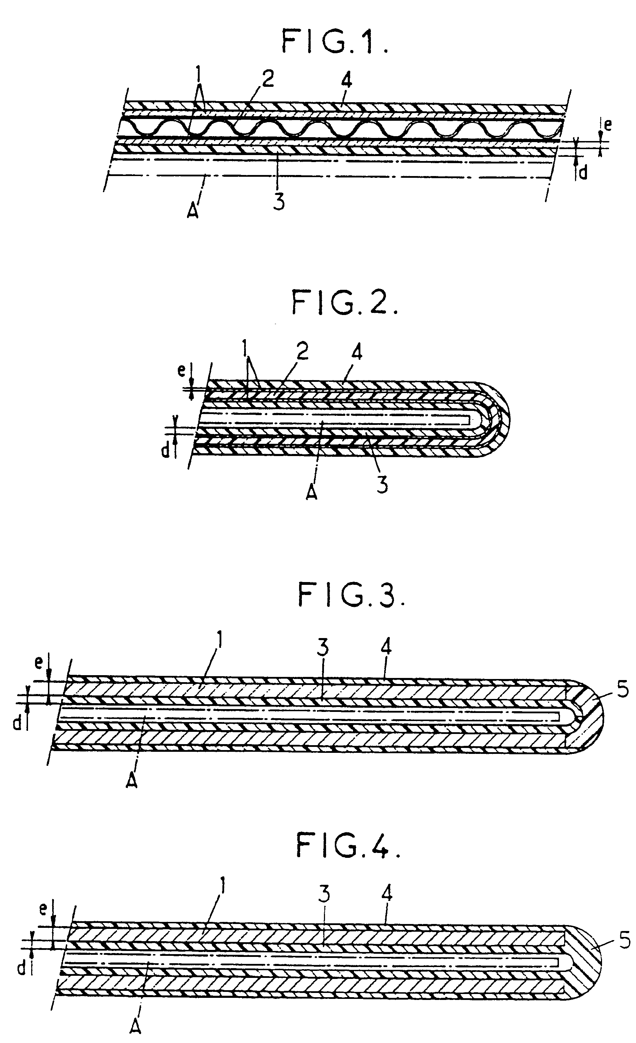

Sur ces figures 1 à 3 on a montré divers aspects de l'invention, le dispositif comportant au moins une couche protectrice 1 formée d'un matériau présentant :

    – d'une part, un coefficient de perméabilité magnétique élevé, supérieur à 5 000,
    – et, d'autre part, un champ magnétique coercitif faible, inférieur à 159 A/m (2 Oe).

De préférence, ce matériau présente un coefficient de perméabilité magnétique supérieur à 50 000 et un champ coercitif inférieur à 79,58 A/m (1 Oe).

Ce matériau peut être constitué par un alliage à base de fer et de nickel ou de fer, de nickel et de molybdène qui peut avantageusement être choisi parmi ceux indiqués dans les exemples ci-dessous :

    a/ matériau constitué par un alliage de 36 % de nickel et de 64 % de fer, commercialisé sous l'appellation "SUPRANHYSTER 36" par la société METALIMPHY et dont le coefficient de perméabilité est de 20 000 et le champ magnétique coercitif est de 15,9 A/m (0,2 Oe) ;
    b/ matériau constitué par un alliage de 50 % de nickel et de 50 % de fer, commercialisé sous l'appellation "SUPRANHYSTER 50" par la société METALIMPHY et dont le coefficient de perméabilité est de 90 000 et le champ magnétique coercitif est de 4,77 A/m (0,06 Oe) ;
    c/ matériau constitué par un alliage de 55 % de nickel et de 45 % de fer, commercialisé sous l'appellation "SATIMPHY" par la société METALIMPHY et dont le coefficient de perméabilité est de 200 000 et le champ magnétique coercitif est de 1,19 A/m (0,015 Oe) ;
    d/ matériau constitué par un alliage de 75 % de nickel, de 22 % de fer et de 3 % de molybdène, commercialisé sous l'appellation "MAXIMPHY HB" par la société METALIMPHY et dont le coefficient de perméabilité est de 170 000 et le champ magnétique coercitif est de 1,59 A/m (0,02 Oe).
    e/ matériau constitué par un alliage de 78 % de nickel, de 18 % de fer et de 4 % de molybdène, commercialisé sous l'appellation "MUMETAL" par la société METALIMPHY et dont le coefficient de perméabilité est de 110 000 et le champ magnétique coercitif est de 1,59 A/m (0,02 Oe) ;

D'une façon générale, le matériau formant la couche protectrice 1 peut être un alliage à base de fer et de nickel ou un alliage à base de fer, de nickel et de molybdène, ou un alliage à base de fer, de nickel et de bore, ou un alliage à base de fer, de nickel, de bore et de phosphore.

Afin d'obtenir un gain de poids tout en conservant une même efficacité de protection, il est avantageux de faire comporter au matériau plusieurs couches protectrices 1, séparées mutuellement par des couches intermédiaires 2, formées d'un corps amagnétique, qui pourrait être un corps alvéolaire tel que du carton ondulé ou un plastique à bulles d'air. Aux figures 1 et 2 on a représenté un tel matériau constitué de deux couches protectrices 1 séparées par une couche intermédiaire 2.

Pour maintenir l'objet à protéger à une distance d déterminée de la couche protectrice 1, on revêt celle-ci d'une couche 3, dite "couche d'écartement", formée d'un corps amagnétique : cette distance d peut être du même ordre de grandeur que l'épaisseur e de la couche protectrice (figures 1, 2 et 3).

Enfin, notamment pour donner un aspect esthétique au matériau, la couche protectrice 1 peut être revêtue d'une couche extérieure 4 formée d'un corps amagnétique (figures 1, 2 et 3).

Le corps amagnétique formant la couche intermédiaire 2, la couche d'écartement 3 et la couche extérieure 4 peut être constitué par un plastique ou un carton appropriés ou encore par du cuir : ce corps amagnétique peut être le même pour réaliser les trois susdites couches (figures 2 et 3).

Il est avantageux, pour des questions de réorientation dans le matériau constituant la couche protectrice, de faire subir à ce matériau, après sa mise en forme éventuelle, un traitement thermique consistant en un réchauffage le portant à une température supérieure à la température de son point de Curie, c'est-à-dire à la température pour laquelle il perd ses propriétés magnétiques : ce réchauffage s'effectue généralement jusqu'à une température de 1000°C à 1100°C.

Sur les figures 2 et 3, on a représenté deux formes d'exécution d'un étui pour carte bancaire ou disquette.

Sur la figure 2, l'étui est réalisé avec un matériau comportant deux couches protectrices minces 1 entourant complètement l'objet à protéger A : les deux couches protectrices peuvent être en MUMETAL de 0,2 mm d'épaisseur ; la couche intermédiaire 2, la couche d'écartement 3 et la couche extérieure 4 sont formées en ABS ou en polyéthylène et présentent la même épaisseur de 0,2 mm.

Sur la figure 3, l'étui est réalisé avec un matériau comportant une seule couche protectrice 1 régnant uniquement de part et d'autre de l'objet à protéger A, les chants 5 de l'étui pouvant être constitués par une pièce rapportée en matériau amagnétique : les deux couches protectrices peuvent être en MUMETAL de 0,8 mm d'épaisseur ; la couche d'écartement 3 et la couche extérieure 4 sont formées en ABS ou en polyéthylène et présentent respectivement une épaisseur de 0,8 mm (couche d'écartement 3) et de 0,3 mm (couche extérieure 4).

L'étui représenté à la figure 4 est de même constitution générale que celui de la figure 3, mais il peut être fabriqué de façon simple et en grande série du fait que la couche d'écartement 3, la couche extérieure 4 et les chants 5 constituent une pièce de matériau plastique unique qui peut être obtenue par injection de matière plastique, amagnétique, autour des plaques 1 en mumétal.

Les étuis montrés sur ces figures 2 et 3 peuvent être dimensionnés pour abriter des cartes bancaires ou des disquettes de divers diamètres.

Bien entendu, l'ouverture présentée par l'étui pour l'introduction ou le retrait de l'objet à protéger A est avantageusement obturable à l'aide d'un couvercle ou capuchon, notamment amovible ou basculant ou coulissant, qui peut être réalisé en tout matériau approprié, en particulier soit un matériau amagnétique (tel que celui des chants 5), soit un matériau présentant d'une part un coefficient de perméabilité magnétique élevé supérieur à 5 000 et d'autre part un champ coercitif faible inférieur à 159 A/m (2 Oe).

**Revendications**

1. Dispositif de protection, contre le flux magnétique environnant, d'objets susceptibles d'être altérés par un flux magnétique, notamment d'objets présentant un support d'inscriptions magnétiques, caractérisé par le fait qu'il comporte au moins une couche protectrice (1) formée d'un matériau présentant, d'une part, un coefficient de perméabilité magnétique élevé supérieur à 5 000 et, d'autre part, un champ magnétique coercitif faible inférieur à 159 A/m (2 Oe) et par le fait que la couche protectrice (1) est revêtue d'une couche dite d'écartement (3), formée d'un corps amagnétique et dont l'épaisseur permet de maintenir l'objet à protéger à une distance déterminée (d) de la couche protectrice (1).

2. Dispositif de protection selon la revendication 1, caractérisé par le fait que la couche protectrice (1) est formée d'un matériau présentant, d'une part, un coefficient de perméabilité magnétique supérieur à 50 000 et, d'autre part, un champ magnétique coercitif inférieur à 79,58 A/m (1 Oe).

3. Dispositif de protection selon la revendication 1 ou 2, caractérisé par le fait qu'il comporte au moins deux couches protectrices (1) séparées par une couche intermédiaire (2) formée d'un corps amagnétique.

4. Dispositif de protection selon l'une quelconque des revendications 1 à 3, caractérisé par le fait que la distance (d) est du même ordre de grandeur que l'épaisseur (e) de la couche protectrice (1).

5. Dispositif de protection selon l'une quelconque des revendications 1 à 4, caractérisé par le fait que la couche protectrice (1) est revêtue d'une couche extérieure (4) formée d'un corps amagnétique.

6. Dispositif de protection selon l'une quelconque des revendications 3 à 5, caractérisé par le fait que la couche intermédiaire (2) est un corps alvéolaire.

7. Dispositif de protection selon l'une quelconque des revendications 3 à 6, caractérisé par le fait que la couche intermédiaire (2) et/ou la couche d'écartement (3) et/ou la couche extérieure (4) sont formées par le même matériau amagnétique.

8. Dispositif de protection selon l'une quelconque des revendications 1 à 7, caractérisé par le fait que le matériau à coefficient de perméabilité magnétique élevé formant la couche protectrice (1) est un alliage à base de fer et de nickel ou un alliage à base de fer, de nickel et de molybdène, ou un alliage à base de fer, de nickel et de bore, ou un alliage à base de fer, de nickel, de bore et de phosphore.

9. Dispositif de protection selon l'une quelconque des revendications 1 à 8, caractérisé par le fait qu'il est agencé pour former un étui, un boîtier, un carter, ou toute autre structure, et ce en fonction de l'objet ou des objets à protéger.

10. Dispositif de protection selon l'une quelconque des revendications 1 à 9, caractérisé par le fait que le matériau formant la couche protectrice se présente en plaque, en fil, en grain ou en poudre.

**Patentansprüche**

1. Vorrichtung zum Schützen von Gegenständen, die durch einen magnetischen Fluß verändert werden können, insbesondere von Gegenständen, die einen magnetischen Aufzeichnungsträger besitzen, vor einem umgebenden magnetischen Fluß, gekennzeichnet durch die Tatsache, daß sie wenigstens eine schützende Schicht (1) aufweist, die aus einem Material besteht, das auf der einen Seite einen magnetischen Permeabilitätskoeffizienten größer als 5000 aufweist und auf der anderen Seite ein schwaches magnetisches Koerzitivfeld von 159 A/m (2 Oe) aufweist, und durch die Tatsache, daß die schützende Schicht (1) mit einer sogenannten Abstandsschicht (3) überzogen ist, die aus einem unmagnetischen Körper gebildet ist und deren Dicke erlaubt, den zu schützenden Gegenstand in einem gegebenen Abstand (d) von der schützenden Schicht (1) zu halten.

2. Schutzvorrichtung nach Anspruch 1, gekennzeichnet durch die Tatsache, daß die schützende Schicht (1) aus einem Material geformt ist, das auf der einen Seite einen magnetischen Permeabilitätskoeffizienten größer als 50000 aufweist und auf der anderen Seite ein schwaches magnetisches Koerzitivfeld von 79,58 A/m (1 Oe) aufweist.

3. Schutzvorrichtung nach Anspruch 1 oder 2, gekennzeichnet durch die Tatsache, daß sie wenigstens zwei schützende Schichten (1) besitzt, die von einer Zwischenschicht (2) aus einem unmagnetischen Material getrennt sind.

4. Schutzvorrichtung nach einem der Ansprüche 1 bis 3, gekennzeichnet durch die Tatsache, daß der Abstand (d) von der gleichen Größenordnung ist wie die Dicke (e) der Schutzschicht (1).

5. Schutzvorrichtung nach einem der Ansprüche 1 bis 4, gekennzeichnet durch die Tatsache, daß die Schutzschicht (1) von einer äußeren Schicht (4) aus einem unmagnetischen Körper bedeckt ist.

6. Schutzvorrichtung nach einem der Ansprüche 3 bis 5, gekennzeichnet durch die Tatsache, daß die Zwischenschicht (2) ein wabenförmiger Körper ist.

7. Schutzvorrichtung nach einem der Ansprüche 3 bis 6, gekennzeichnet durch die Tatsache, daß die Zwischenschicht (2) und/oder die Abstandsschicht (3) und/oder die äußere Schicht (4) aus demselben unmagnetischen Material bestehen.

8. Schutzvorrichtung nach einem der Ansprüche 1 bis 7, gekennzeichnet durch die Tatsache, daß das Material mit einem hohen magnetischen Permeabilitätskoeffizienten, das die Schutzschicht (1) bildet, eine Legierung auf Eisen-Nickel-Basis oder eine Legierung auf Eisen-Nickel-Molybdän-Basis oder eine Legierung auf Eisen-Nickel-Bor-Basis oder eine Legierung auf Eisen-Nickel-Bor-Phosphor-Basis ist.

9. Schutzvorrichtung nach einem der Ansprüche 1 bis 8, gekennzeichnet durch die Tatsache, daß sie bearbeitet ist, um ein Futteral, einen Kasten, eine Wanne oder jede andere Struktur zu bilden, und das als Funktion des oder der zu schützenden Gegenstände.

10. Schutzvorrichtung nach einem der Ansprüche 1 bis 9, gekennzeichnet durch die Tatsache, daß das Material, das die Schutzschicht bildet, sich in als Scheibe, Draht, Granulat oder Pulver darstellt.

## Claims

1. Device for protecting against the environing magnetic flux, objects which are likely to be altered by a magnetic flux, particulary objects having a magnetic recording support medium, characterized in that it comprises at least one protective layer (1) formed of a material having a high magnetic permeability coefficient greater than 5 000 and a low coercitive magnetic field less than 159 A/m (2 Oe), and that the protective layer (1) is coated with a so-called spacer layer (3) formed of an amagnetic substance and whose thickness holds the object to be protected at a given distance (d) from the protective layer (1).

2. Protection device according to claim 1, characterized in that the protective layer (1) is formed of a material having a magnetic permeability coefficient higher than 50 000 and a coercitive magnetic field less than 79,58 A/m (1 Oe).

3. Protection device according to claim 1 or 2, characterized in that it includes at least two protective layers (1), separated by an intermediate layer (2) formed of an amagnetic substance.

4. Protection device according to any of claims 1 to 3, characterized in that the distance (d) is of the same order of size as the thickness (e) of the protective layer (1).

5. Protection device according to any of claims 1 to 4, characterized in that the protective layer (1) is coated with an external layer (4) formed of an amagnetic substance.

6. Protection device according to any of claims 3 to 5, characterized in that the intermediate layer (2) is a cellular substance.

7. Protection device according to any of claims 3 to 6, characterized in that the intermediate layer (2) and/or the spacer layer (3) and/or the external layer (4) are formed from the same amagnetic substance.

8. Protection device according to any of claims 1 to 7, characterized in that the high magnetic permeability coefficient material forming the protection layer (1) is an iron and nickel based alloy or an iron, nickel and molybdenum based alloy or an iron, nickel and boron based alloy or an iron, nickel, boron and phosphorous based alloy.

9. Protection device according to any of claims 1 to 8, characterized in that it is adapted so as to form a case, a box, a housing or any other structure depending on the object or objects to be protected.

10. Protection device according to any of claims 1 to 9, characterized in that the material forming the protective layer (1) is in the form of a plate, thread, grains or powder.

# FIG.1.

e

d

1  2  4

A  3

# FIG.2.

e

d

1  2  4

A  3

# FIG.3.

e

d

1  3  4

5

A

# FIG.4.

e

d

1  3  4

5

A